(19) Europäisches Patentamt / European Patent Office / Office européen des brevets

(11) **EP 4 116 084 A1**

(12) **EUROPEAN PATENT APPLICATION**
published in accordance with Art. 153(4) EPC

(43) Date of publication:
**11.01.2023 Bulletin 2023/02**

(21) Application number: **21764394.9**

(22) Date of filing: **25.02.2021**

(51) International Patent Classification (IPC):
**B32B 9/00** (2006.01)   **C23C 14/06** (2006.01)
**B32B 7/025** (2019.01)   **G06F 3/041** (2006.01)

(52) Cooperative Patent Classification (CPC):
**B32B 7/025; B32B 9/00; C23C 14/06; G06F 3/041**

(86) International application number:
**PCT/JP2021/007001**

(87) International publication number:
**WO 2021/177124 (10.09.2021 Gazette 2021/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.03.2020 JP 2020035784**

(71) Applicant: **Dexerials Corporation**
**Shimotsuke-shi, Tochigi 323-0194 (JP)**

(72) Inventor: **Wako, Hitoshi**
**Shimotsuke-shi, Tochigi 3230194 (JP)**

(74) Representative: **Müller-Boré & Partner**
**Patentanwälte PartG mbB**
**Friedenheimer Brücke 21**
**80639 München (DE)**

(54) **ELECTROCONDUCTIVE LAMINATE, OPTICAL DEVICE IN WHICH SAME IS USED, AND METHOD FOR PRODUCING ELECTROCONDUCTIVE LAMINATE**

(57)   Provided are a conductive laminate having low electric resistance and high transmittance over a long period of time, various optical elements provided with the conductive laminate, and a method for manufacturing the conductive laminate. In the conductive laminate 1 according to the present technology, a first transparent material layer 3, a metal layer 4 mainly composed of silver, and a second transparent material layer 5 are laminated on at least one surface of the transparent substrate 2 in this order from the transparent substrate 2 side. The first transparent material layer 3 is composed of a composite metal oxide containing at least zinc and tin and containing 10 atomic% or more and 90 atomic% or less of tin. The second transparent material layer 5 is composed of a metal oxide containing zinc and having a tin content of 10 atom% or less.

FIG.1

**Description**

TECHNICAL FIELD

The present technology relates to a conductive laminate used, e.g., in a touch panel, a light control element, an electrophoretic optical element, a light emitting element, and an antenna. This application claims priority on the basis of Japanese Patent Application Serial No. 2020-035784 filed March 3, 2020 in Japan, which is incorporated by reference herein.

BACKGROUND ART

Conventionally, transparent and electrically conductive materials have been utilized in a variety of optical devices. Examples include a touch panel which is laminated on an image display device and detects a touched position based on a change in capacitance, a light control element which electrically variably adjusts a strong external light by utilizing electrochromic phenomena, a light emitting element which utilizes electroluminescence phenomena, an electrophoretic optical element which controls fine particles having charges dispersed in a liquid by an electric field, and an antenna that can be pasted on a window without impairing visibility.

The electrodes used in these optical devices are required to be optically transparent, and it is necessary to increase electrical conductivity due to operational reasons. Therefore, there is required a material that is transparent and has low electric resistance. As a material of this kind, ITO (indium tin oxide), which is a composite oxide of indium and tin, is widely used. ITO already has a large market position. However, in order to reduce the resistance value and enhance the transparency of ITO, it is necessary to form a film at a high temperature or to apply a heat treatment after the film formation, so that there has been a problem when it is used for substrates or elements that are weak to heat.

For this reason, development of materials which can achieves a low resistance and high transparency without heating are progressing, and there has been studied the use of zinc oxides such as Zn-O, In-Zn-O (IZO), Al-Zn-O (AZO), and Sn-Zn-O (ZTO) as a substitute for ITO. Among these zinc-based oxides, AZO and ZTO are preferred because they do not contain indium, which is feared to affect the human body.

In a plasma television or the like, electromagnetic waves are emitted from the screen due to the configuration of the device. Various transparent materials have been developed to absorb the electromagnetic wave, and it was found that a laminate made by sandwiching a very thin silver thin film with transparent materials having a high refractive index was very effective, and research and development for these materials were widely carried out. This laminate achieves a low resistance and a high transmittance by having electrical conductivity with silver and by suppressing the surface reflection to increase the transmittance by the optical interference effect between the high refractive index material and the silver. In some cases, this laminate is applied to the above-mentioned optical devices.

As described above, a transparent conductive film having both transmissivity and conductivity can be used in various applications; further lower resistance and higher transmittance are required for power-saving and high-speed operation of the elements. In the case of a metal oxide such as ITO, it is necessary to increase the thickness of the film in order to decrease the resistance value, and it is difficult to obtain sufficient properties because the transmittance decreases when increasing the film thickness. For this reason, a laminate having a metal layer sandwiched by a transparent material is considered very useful. In particular, the laminate exemplified in Patent Document 2, in which a silver layer is sandwiched by tin-zinc composite oxide as the transparent material, has chemical stability of the tin-zinc composite oxide and excellent water vapor barrier performance and thus can suppress the deterioration of the silver thin film and have stable characteristics.

CITATION LIST

PATENT LITERATURE

Patent Document 1: Japanese Patent No. 4820738
Patent Document 2: Japanese Patent No. 4961786

NON PATENT LITERATURE

Non-Patent Document 1: Appl. Phys. A (2014) 116: 1287-1291

SUMMARY OF INVENTION

TECHNICAL PROBLEM

However, it has been found that when a conductive laminate in which a silver layer is sandwiched by conductive thin films of tin-zinc composite oxide as the transparent material is stored under an accelerated environment of high temperature and high humidity, although the performance of transmittance is maintained, the surface resistance increases rapidly so that this conductive laminate tends to be difficult to be used as a conductive film. This indicates that there is a problem in using the conductive laminate for a long period of time.

Therefore, there is a need for a conductive laminate having a high transmittance and capable of maintaining a low electrical resistance even after storage under an accelerated environment of high temperature and high humidity. In addition, the indium-tin composite oxide used as the conductive film is a rare material, and it is desired not to use indium, which is feared to affect human bodies.

Therefore, the present technology has been developed in view of the above problems, and an object thereof is to provide a conductive laminate having a low electric resistance and a high transmittance over a long period of time, various optical elements provided with the conductive laminate, and a method for manufacturing the conductive laminate.

SOLUTION TO PROBLEM

As a result of intensive research to solve the above problem, the present inventors have found that in a conductive laminate in which a first transparent material layer, a metal layer mainly composed of silver, and a second transparent material layer are laminated on at least one surface of a transparent substrate in this order from the transparent substrate side, forming the first transparent material layer with a composite metal oxide containing at least zinc and a predetermined amount of tin, and forming the second transparent material layer with a metal oxide containing zinc and a predetermined amount or less of tin can achieve high transmittance and low electric resistance, thereby completing the present invention.

Specifically, a conductive laminate according to the present technology includes: a first transparent material layer, a metal layer mainly composed of silver, and a second transparent material layer which are laminated on at least one surface of a transparent substrate in this order from the transparent substrate side, wherein the first transparent material layer is composed of a composite metal oxide containing at least zinc and tin and containing 10 atomic% or more and 90 atomic% or less of tin, and wherein the second transparent material layer is composed of a metal oxide containing zinc and having a tin content of 10 atomic% or less.

An optical device according to the present technology is configured by using the above-mentioned conductive laminate as at least one pole of an electrode.

A method for manufacturing a conductive laminate according to the present technology includes a step of laminating, on at least one surface of a transparent substrate, a first transparent material layer, a metal layer mainly composed of silver, and a second transparent material layer in this order from the transparent substrate side, wherein the first transparent material layer is composed of a composite metal oxide containing at least zinc and tin and containing 10 atomic% or more and 90 atomic% or less of tin, and wherein the second transparent material layer is composed of a metal oxide containing zinc and having a tin content of 10 atomic% or less.

ADVANTAGEOUS EFFECTS OF INVENTION

The present technology can suppress the formation of the light absorbing layer at each interface of the conductive laminate, thereby providing the conductive laminate having low electrical resistance and high transmittance over a long period of time; this conductive laminate can be applied as an electrode of various optical devices such as a power-saving and high-performance touch panel, a light control element, an antenna, an electrophoretic element, and a light emitting element.

BRIEF DESCRIPTION OF DRAWINGS

FIG. 1 is a cross-sectional view schematically illustrating a configuration of a conductive laminate according to the present technology.

FIG. 2 is a perspective view illustrating an example of the internal configuration of a thin film forming apparatus.

DESCRIPTION OF EMBODIMENTS

Hereinafter, a conductive laminate according to the present technology, an optical device using the same, and a method for manufacturing the conductive laminate will be described in detail with reference to the drawings. It should be noted that the present disclosure is not limited to the following embodiments and various modifications can be made without departing from the scope of the present disclosure. Moreover, the features illustrated in the drawings are shown schematically and are not intended to be drawn to scale. Actual dimensions should be determined in consideration of the following description. Furthermore, those skilled in the art will appreciate that dimensional relations and proportions may be different among the drawings in certain parts.

Conductive Laminate

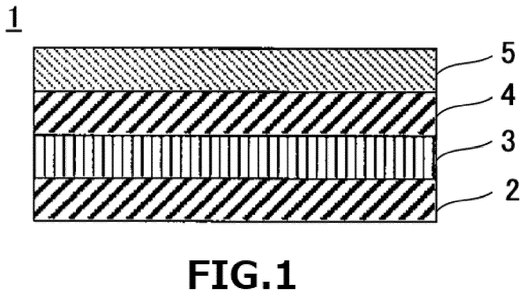

FIG. 1 is a cross-sectional view schematically illustrating a configuration of a conductive laminate 1 according to the present technology. As shown in FIG. 1, the conductive laminate 1 is a conductive laminate in which a first transparent material layer 3, a metal layer 4 mainly composed of silver, and a second transparent material layer 5 are laminated in this order on at least one surface of a transparent substrate 2 from the transparent substrate 2 side. In the conductive laminate 1, the first transparent material layer 3 is composed of a composite metal oxide containing at least zinc and tin and containing 10 atomic% or more and 90 atomic% or less of tin, and the second transparent material layer 5 is composed of a metal oxide containing zinc and having a tin content of 10 atomic% or less.

The respective layers 3 to 5 of the conductive laminate 1 can be formed by sputtering, which is one of vacuum deposition techniques. The inventors of the present invention conducted a study by laminating various transparent materials and silver by sputtering, and found that light absorption can be suppressed by using a composite oxide containing zinc and tin and containing 10 atomic% or more and 90 atomic% or less of tin as the first transparent material layer 3, and low electrical resistance can be maintained over a long period of time by using a metal oxide containing zinc and having a tin content of 10 atomic% or less as the second transparent material layer 5.

Here, when zinc oxide is used as the first transparent material layer 3, a light-absorbing layer is formed when silver is deposited by sputtering after zinc oxide is deposited. That is, when the silver atoms that have jumped out from the target at high speed reach the transparent substrate 2, they lose kinetic energy and are fixed on the surface of the transparent substrate 2. At this time, if the silver atoms that have jumped out from the target at high speed and the metals constituting the first transparent material layer 3 interact strongly, the silver atoms are alloyed on the first transparent material layer 3 side, thereby forming a light absorbing layer. Further, since zinc has a wide solid solution region with silver constituting the metal layer 4 and is an element having a strong interaction with silver constituting the metal layer 4, the light absorbing layer is easily formed.

However, the first transparent material layer 3 containing tin as in the present technology, especially the first transparent material layer 3 in which the content of tin is 10 atomic% or more and 90 atomic% or less with regard to the total amount of zinc and tin can suppress the reaction with silver constituting the metal layer 4 to form a thin film due to the chemical stability of the composite oxide of zinc and tin.

If the second transparent material layer 5 is formed by a material having a low interaction with silver constituting the metal layer 4, the second transparent material layer 5 is not sufficiently wet-spread, and a large number of small voids are formed at the interface, where light absorption occurs. On the contrary, using a metal oxide containing zinc to form the second transparent material layer 5 can improve wettability on the surface and form an excellent interface. In addition, since the bonding of zinc and oxygen is strong, the zinc forms an oxide film before forming an alloy with silver constituting the metal layer 4, thereby more effectively suppressing the formation of the light absorbing layer of the alloy. The conductive oxide practically applicable to the second transparent material layer 5 includes zinc oxide and zinc alloy composite oxide. The zinc oxide and zinc alloy composite oxide are preferred because they have good contact resistance when substantially transferring charge from the outside to the surface of the conductive laminate 1. However, when a composite oxide of zinc and tin is used for the second transparent material layer 5, the strong bonding tends to make it difficult to obtain electrical conductivity in stable phase. Generally conceivable method for achieving good electrical conductivity will include intentionally reducing the oxygen content in the composite oxide from the stoichiometric composition and adjusting the amount of oxygen introduced during sputtering. However, although the composite oxide of zinc and tin is electrically conductive immediately after the film formation, it tends to gradually lose its electrical conductivity since holding the composite oxide for a long period of time will progress the oxidization by oxygen in the atmosphere.

As described above, the required characteristics are different between the first transparent material layer 3 and the second transparent material 5. Specifically, in the first transparent material layer 3, chemical stability is required and electrical conductivity is not so important, while in the second transparent material layer 5, electrical conductivity is important. The addition of tin oxide to zinc oxide increases chemical stability, but at the same time deteriorates electrical conductivity. Therefore, if the compositions of the first transparent material layer 3 and the second transparent material layer 5 are the same, it is difficult to achieve the effect of the present technology.

In the present technology, by laminating, on at least one surface of the transparent substrate 2, a first transparent material layer 3 composed of a composite metal oxide containing at least zinc and tin and containing 10 atomic% or more and 90 atomic% or less of tin, a metal layer 4 consisting mainly of silver, and a second transparent material layer 5 composed of a metal oxide containing zinc and having a tin content of 10 atomic% or less in this order from the transparent substrate 2 side, light absorption at each interface can be suppressed. Thus, the conductive laminate 1 having low electrical resistance and high transmittance for a long period of time can be obtained without using indium.

Further, the conductive laminate 1 of the present technology can reduce the surface resistance (electric resistance) and increase the total light transmittance. For example, the conductive laminate 1 may have a surface resistance of 20 $\Omega$/square or less and a total light transmittance of 90% or more. The method for measuring the surface resistance and the total light transmittance is the same as the measuring method in the examples described later. It should be noted that generally used ITO (indium tin complex oxide) films have a surface resistance of 100 $\Omega$/square and a total light transmittance of 88% in many cases, although this varies depending on the ITO film thickness.

Therefore, the present technology can be applied to a power-saving and high-performance optical device using at least one conductive laminate 1, e.g., a touch panel, a light control element, an electrophoretic optical element, a light emitting element, and an antenna using the conductive laminate as at least one pole of an electrode.

Hereinafter, each layer constituting the conductive laminate 1 will be described in detail. As described above, in the conductive laminate 1 according to the present technology, a first transparent material layer 3, a metal layer 4 mainly composed of silver, and a second transparent material layer 5 are laminated on at least one surface of the transparent substrate 2 in this order from the transparent substrate 2 side.

TRANSPARENT SUBSTRATE

The transparent substrate 2 can be made of either a glass substrate or a resin film. The transparent substrate 2 composed of a resin film can be manufactured by a roll-to-roll method so as to improve production efficiency.

The material of such resin film is not particularly limited, and may be, e.g., polyethylene terephthalate (PET), polyethylene naphthalate (PEN), polyaramide, polyimide, polycarbonate, polyethylene, polypropylene, triacetylcellulose (TAC), and polycycloolefin (COC: cyclic olefin copolymer, COP: cyclic olefin copolymer), among others.

The thickness of the transparent substrate 2 is not particularly limited, but is preferably 20 $\mu$m or more and 200 $\mu$m or less in consideration of the ease of handling in manufacturing and the thinning of the member when the resin film is used.

In the conductive laminate 1, the transparent substrate 2 does not need to have a light transmittance of 100%, but may be transparent within a range in which the effect of the present technology is achieved, and for example, it is preferable that the light transmittance is 88% or more.

In order to improve the scratch resistance of the transparent substrate 2, thin films of, e.g., acrylic resin may be formed on both surfaces of the transparent substrate 2 by solution coating.

FIRST TRANSPARENT MATERIAL LAYER

The first transparent material layer 3 is composed of a composite oxide of zinc and tin as described above, and the ratio of tin is 10 to 90 atomic% with regard to the total amount of zinc and tin. The first transparent material layer 3 may contain one or more elements other than zinc and tin within a range not exceeding 50 atomic% with regard to the total amount of zinc and tin.

The thickness of the first transparent material layer 3 is not particularly limited, and can be set to a film thickness having the highest transmittance according to the material configuration. The first transparent material layer 3 may have an actual thickness in the range of 30 to 80 nm.

The method of forming the first transparent material layer 3 is not particularly limited, but it is preferable to use a sputtering method in order to improve production efficiency and equalize the film thickness distribution.

The first transparent material layer 3 may be formed as a plurality of layers from the viewpoint of moisture-proof property. In this case, in the plurality of first transparent material layers 3, at least the transparent material layer in contact with the metal layer 4 is composed of a composite metal oxide containing zinc and tin and containing 10 atomic% or more and 90 atomic% or less of tin.

METAL LAYER

The metal layer 4 laminated on the first transparent material layer 3 is a metal layer mainly composed of silver. The metal layer 4 may contain 90 atomic% or more of silver, and may also contain additional elements in a range not exceeding 10 atomic% in total. In other words, the metal layer 4 can be composed of 90 atom% or more of silver or pure silver.

The thickness of the metal layer 4 is preferably 5 nm or more. The metal layer 4 having a film thickness of 5 nm or more can be easily formed as a continuous film and can suppress absorption which would be caused by the formation of islands of silver constituting the metal layer 4. In other words, the metal layer 4 having a film thickness of less than 5 nm tends to form an island-like film and might inhibit light transmission. The upper limit of the film thickness of the metal layer 4 is not particularly limited, but is preferably less than 15 nm. By making the film thickness of the metal layer 4 less than 15 nm, it is possible to more effectively suppress the increase in the optical absorption inside the silver layer constituting the metal layer 4 so that this optical absorption would not exceed the absorption at the interface.

Although the method of forming the metal layer 4 is not particularly limited, it is preferable to form the second transparent material layer 5 continuously after the formation of the metal layer 4, and it is preferable to use a sputtering method from the viewpoint of improving production efficiency and equalizing the film thickness distribution.

SECOND TRANSPARENT MATERIAL LAYER

The second transparent material layer 5 laminated on the metal layer 4 is made of a metal oxide containing zinc and having a tin content of 10 atom% or less as described above. In particular, the content of tin in the second transparent material layer 5 is preferably smaller than the content of tin in the first transparent material layer 3 from the viewpoint of further enhancing the effect of the present technology. The lower limit value of the content of tin in the second transparent material layer 5 is not particularly limited and may be 0 atomic%, 1 atomic% or more, 4 atomic% or more, 6 atomic% or more, or 8 atomic% or more.

From the viewpoint of optical properties, electrical conductivity, and chemical stability, the second transparent material layer 5 may contain one or more elements other than zinc within a range not exceeding 50 atomic%. In particular, the second transparent material layer 5 preferably contains 2 atomic% or more of at least one of aluminum and gallium, and more preferably contains 2 atomic% or more of aluminum or gallium. Thus, the electrical conductivity of the second transparent material layer 5 can be further improved. When the second transparent material layer 5 contains at least one of aluminum and gallium, the upper limit of the total amount of aluminum and gallium is not particularly limited, and may be, e.g., 15 atomic% or less, 12 atomic% or less, 10 atomic% or less, 8 atomic% or less, or 5 atomic% or less.

The thickness of the second transparent material layer 5 is not particularly limited, and can be set to a film thickness having the highest transmittance in accordance with the material configuration. The actual thickness of the second transparent material layer 5 may be in a range of, e.g., 30 to 70 nm.

Although the method of forming the second transparent material layer 5 is not particularly limited, it is preferable to form the second transparent material layer 5 continuously after the formation of the metal layer 4, and it is preferable to use a sputtering method from the viewpoint of improving production efficiency and equalizing the film thickness distribution.

The second transparent material layer 5 may be formed in a plurality of layers from the viewpoint of scratch resistance property. In this case, at least the transparent material layer in contact with the metal layer 4 among the plurality of second transparent material layers 5 is composed of a metal oxide containing zinc and having a tin content of 10 atomic% or less, and may contain one or more kinds of elements within a range not exceeding 50 atomic%. Furthermore, in the plurality of second transparent material layers 5, the layers other than the transparent material layer in contact with the metal layer 4 are preferably transparent oxides having electrical conductivity in order to maintain good electrical conductivity.

Although the conductive laminate 1 shown in FIG. 1 is formed by laminating the first transparent material layer 3, the metal layer 4, and the second transparent material layer 5 on one surface of the transparent substrate 2, the first transparent material layer 3, the metal layer 4, and the second transparent material layer 5 may be laminated on the other surface of the transparent substrate 2 or on both surfaces of the transparent substrate 2.

MANUFACTURING METHOD OF CONDUCTIVE LAMINATE

The conductive laminate 1 described above can be manufactured by a process of laminating the first transparent material layer 3, the metal layer 4 mainly composed of silver, and the second transparent material layer 5 on at least one surface of the transparent substrate 2 in this order from the transparent substrate 2 side.

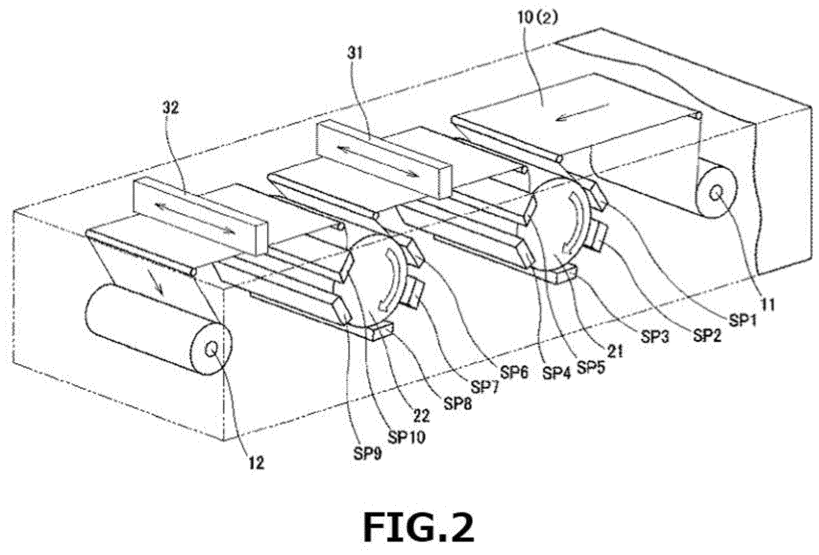

The first transparent material layer 3, the metal layer 4, and the second transparent material layer 5 may be formed by using, e.g., a thin film forming apparatus disclosed in Japanese Unexamined Patent Application Publication No. 2014-34701. FIG. 2 is a perspective view illustrating an internal configuration of a thin film forming apparatus disclosed in Japanese Unexamined Patent Application Publication No. 2014-34701. This thin film forming apparatus forms a film on a film substrate by sputtering with a roll-to-roll method, allowing a plurality of sputtering targets to be installed, and allowing a plurality of kinds of different materials to be formed while maintaining a vacuum atmosphere once the roll is set.

In addition, at the time of sputtering, this thin film forming apparatus can introduce oxygen gas into the plasma in addition to argon gas used as a sputtering gas, thereby forming the oxide of the target material on the film base material.

Hereinafter, the structure of the thin film forming apparatus will be described in detail. The thin film forming apparatus is provided with: a measurement unit to which a base film is continuously supplied in the longitudinal direction to measure optical properties in the width direction of a thin film formed on the base film; a supply unit provided with a plurality of gas nozzles in the width direction of the base film to supply reactive gas near the target; and a control unit to control the flow rate of reactive gas ejected from each gas nozzle based on the optical properties in the width direction measured by the measurement unit, thereby forming a thin film of uniform thickness in the longitudinal direction and the width direction.

Further, a specific configuration may preferably be provided with a film forming part including: a supply unit, a sputtering electrode for applying a voltage to a target, and a plasma measuring unit for measuring the emission spectrum of the plasma in the width direction of the substrate film during film formation. With this configuration, the control unit can control the flow rate of the reactive gas ejected from each gas nozzle and the voltage applied to the target on the basis of the optical properties in the width direction measured by the measuring unit and the emission spectrum measured by the plasma measuring unit, thereby forming a thin film having a more uniform thickness in the width direction.

Further, a specific configuration may include: an unwinding part for winding out the base film in the longitudinal direction, a film forming unit in which a plurality of film forming parts are arranged in the longitudinal direction of the base film, and a winding part for winding the base film on which the thin film is formed in the film forming unit. Thus, a multilayer thin film can be formed during the processes between the unwinding and the winding of the base film. It is preferable to dispose the measuring unit at least after the last film forming part, i.e., between the film forming unit and the winding part, and it is more preferable to dispose a plurality of the measuring units after each of the plurality of the measuring parts, respectively. Thus, the optical properties of both the single-layer thin film and the multi-layer thin film can be measured.

The thin film forming apparatus shown in FIG. 2 feeds a base material film serving as the base film while winding it around a can roll to form a thin film on the surface of the base film by sputtering.

In this thin film forming apparatus, a base film 10 (transparent substrate 2) is supplied from an unwinding roll 11 functioning as the unwinding part and the base film 10 having the thin film formed thereon is wound by a winding roll 12 functioning as the winding part. A first film forming chamber unit and a second film forming chamber unit functioning as the film formation units are provided in a vacuum chamber. The vacuum chamber is connected to a vacuum pump for discharging air and can be adjusted to a predetermined degree of vacuum.

The first film forming chamber unit and the second film forming chamber unit are respectively provided with a first can roll 21 and a second can roll 22, and a plurality of sputtering chambers SP1 to SP10 functioning as the film forming units are fixed so as to face the outer peripheral surfaces of the can rolls 21, 22. In each of the sputtering chambers SP1 to SP10, a predetermined target is mounted above the electrode, and a supply part having a plurality of gas nozzles in the width direction of the base film 10 is provided.

In addition, the thin film forming apparatus is provided with an optical monitor 31 functioning as the measuring unit for measuring optical properties between the first film forming chamber unit and the second film forming chamber unit, i.e., after film formation by the sputtering chamber SP5. Thus, it is possible to control the film formation on an intermediate product conveyed after the first film forming chamber unit and to reduce the adjustment time for adjusting a single layer. In addition, the thin film forming apparatus is further provided with an optical monitor 32 functioning as the measuring unit for measuring optical properties after the second film forming chamber unit, i.e., after film formation by the sputtering chamber SP10. Thus, it is possible to confirm the quality of the final film formation after the second film forming chamber unit.

The optical monitors 31, 32 measure optical properties in the width direction of the thin film formed on the base film 10 by an optical head capable of scanning in the width direction, as will be described later. The optical monitors 31, 32 measure, e.g., the peak wavelength of reflectance as an optical property and convert it into an optical thickness to acquire an optical thickness distribution in the width direction.

The thin film forming apparatus having such a constitution can produce a multilayer thin film by feeding the base film 10 from the unwinding roll 11, forming thin films on the base film 10 conveyed by the first can roll 21 and the second can roll 22, and winding the thin film by the winding roll 12. Here, by measuring optical properties in the width direction of the thin film formed on the base film 10 by using the optical monitors 31, 32, and controlling the flow rate of the reactive gas supplied from each gas nozzle provided in the width direction based on the optical properties, it is possible to form a thin film having a uniform thickness in the longitudinal direction and the width direction.

Examples

Hereinafter, the present technology will be specifically described with reference to examples and comparative examples, but the present invention is not limited to the following examples.

Example 1

A first transparent material layer, a metal layer, and a second transparent material layer were sequentially formed on a transparent substrate by using a thin film forming apparatus disclosed in Japanese Unexamined Patent Application Publication No. 2014-34701 shown in FIG. 2. A COP film of 50 $\mu$m thickness was used as the transparent substrate.

The thin film forming apparatus can simultaneously laminate thin films of a plurality of materials in sequence, and in the present example, targets of 50 atom% tin-containing zinc oxide (hereinafter noted such as "50 atm% Sn-Zn-O"), silver, and zinc oxide are arranged in this order from the side close to the film unwinding side. Each target is connected to an individual power source that can cause discharge by applying arbitrarily controllable power. Further, each target is housed in an independent container, and the partition wall separating the targets has only a small gap near the can roll, so that a substantially different gas atmosphere can be implemented.

A film was formed by a sputtering method by evacuating the entire vacuum chamber of the thin film forming apparatus to $1 \times 10^{-3}$ Pa or less, introducing argon gas into the first cathode part provided with a 50 atm% Sn-Zn-O target in the vacuum chamber while adjusting the flow rate to be 150 sccm by a mass flow controller, and then applying power to the 50 atm% Sn-Zn-O target to cause discharge. At this time, in order to suppress the light absorption in 50 atm% Sn-Zn-O due to oxygen shortage, 6 sccm of oxygen was added to form a transparent oxide layer. The running speed of the film was 3 m/min. After measuring the relation between the electric power and the film thickness in advance, the electric power was adjusted based on the measurement so that 50 atm% Sn-Zn-O having a thickness of 64 nm could be formed at a running speed of 3 m/min.

After 50 atm% Sn-Zn-O was formed in the first cathode part, a silver thin film was formed at the second cathode part. Specifically, a film was formed by a sputtering method by introducing argon gas into the second cathode part in the vacuum chamber while adjusting the flow rate to be 450 sccm by a mass flow controller, and then applying power to the silver target to cause discharge. Although two adjacent cathodes are used in this example, it is not necessary to use two adjacent cathodes. Depending on the configuration of the apparatus, the entire cathode chamber may be used as a partition wall instead of using one cathode chamber. After measuring the relation between the electric power and the film thickness in advance, the electric power was adjusted based on the measurement so that silver film with a thickness of 7 nm could be formed at a running speed of 3 m/min.

After a silver thin film was formed in the second cathode part, a zinc oxide film was formed in the third cathode part. Specifically, a film was formed by a sputtering method by introducing argon gas into the third cathode part of the vacuum chamber while adjusting the flow rate to be 150 sccm by a mass flow controller, and then applying power to the zinc oxide target to cause discharge. At this time, a small amount of oxygen was introduced separately from argon gas while adjusting the amount of oxygen by a mass flow controller so as not to cause poor conductivity due to oxygen deficiency or oxygen excess to obtain an excellent transparent conductive oxide. Although two adjacent cathodes are used in this example, it is not necessary to use two adjacent cathodes. Depending on the configuration of the apparatus, one entire cathode chamber may be used as a partition wall instead of using individual cathode chambers. After measuring the relation between the electric power and the film thickness in advance, the electric power was adjusted based on the measurement so that zinc oxide with a thickness of 46 nm could be formed at a running speed of 3 m/min.

After forming the three layers, a sample was prepared by continuously winding the film having the configure shown in FIG. 1, introducing air into the entire apparatus, and then taking out the sample.

Example 2

A sample was prepared under the same conditions as in Example 1, except that the target installed in the third cathode part was changed from zinc oxide to 10 atom% tin-containing zinc oxide, and the discharge conditions for the third cathode part were adjusted so that the film formation speed was the same as that of zinc oxide.

Example 3

A sample was prepared under the same conditions as in Example 1, except that the target installed in the first cathode part was changed from 50 atom% tin-containing zinc oxide to 10 atom% tin-containing zinc oxide, and the discharge conditions for the first cathode part were adjusted so that the film formation speed was the same as that of 50 atom% tin-containing zinc oxide.

Example 4

A sample was prepared under the same conditions as in Example 1, except that the target installed in the first cathode part was changed from 50 atom% tin-containing zinc oxide to 90 atom% tin-containing zinc oxide, the discharge conditions for the first cathode part were adjusted so that the film thickness was 55 nm, and the discharge conditions for the third cathode part were adjusted so that the film thickness of zinc oxide was 51 nm.

Example 5

A sample was prepared under the same conditions as in Example 1, except that the discharge conditions for the first cathode part were adjusted so that the film thickness of 50 atom% tin-containing zinc oxide was 63 nm, the target installed in the third cathode part was changed from zinc oxide to 5 atom% aluminum-containing zinc oxide, and the discharge conditions for the third cathode part were adjusted so that the film thickness was 46 nm.

Example 6

A sample was prepared under the same conditions as in Example 1, except that the discharge conditions for the first cathode part were adjusted so that the film thickness of 50 atom% tin-containing zinc oxide was 63 nm, the target installed in the third cathode part was changed from zinc oxide to 10 atom% gallium-containing zinc oxide, and the discharge conditions for the third cathode part were adjusted so that the film thickness was 43 nm.

Comparative Example 1

A sample was prepared under the same conditions as in Example 1, except that the target installed in the third cathode part was changed from zinc oxide to 15 atom% tin-containing zinc oxide, and the discharge conditions for the third cathode part were adjusted so that the film formation speed was the same as that of zinc oxide.

Comparative Example 2

A sample was prepared under the same conditions as in Example 1, except that the discharge conditions for the first cathode part were adjusted so that the film thickness of the 50 atom% tin-containing zinc oxide was 65 nm, and the target installed in the third cathode part was changed from zinc oxide to 50 atom% tin-containing zinc oxide, and the discharge conditions for the third cathode part were adjusted so that the film thickness was 47 nm.

Comparative Example 3

A sample was prepared under the same conditions as in Example 1, except that the target installed in the first cathode part was changed from 50 atom% tin-containing zinc oxide to zinc oxide.

Comparative Example 4

A sample was prepared under the same conditions as in Example 1, except that the target installed in the first cathode part was changed from 50 atom% tin-containing zinc oxide to tin oxide, the discharge conditions for the first cathode part were adjusted so that the film thickness was 47 nm, and the discharge conditions for the third cathode part were adjusted so that the film thickness of zinc oxide was 56 nm.

Comparative Example 5

A sample was prepared under the same conditions as in Example 1, except that the target installed in the first cathode was changed from 50 atom% tin-containing zinc oxide to 5 atom% tin-containing zinc oxide.

Comparative Example 6

A sample was prepared under the same conditions as in Example 1, except that the target installed in the first cathode part was changed from 50 atom% tin-containing zinc oxide to 95 atom% tin-containing zinc oxide, and the discharge conditions for the first cathode part were adjusted so that the film thickness was 52 nm, and the discharge conditions for the third cathode part were adjusted so that the film thickness of the zinc oxide was 51 nm.

EVALUATION RESULTS

Each sample was cut to an arbitrary size and then measured and evaluated.

SURFACE RESISTANCE

The surface resistance was measured in accordance with "JIS K-7194" using a contact type resistance measuring instrument "Loresta GP (registered trademark) (manufactured by Dia Instruments)". Specifically, in order to evaluate the long-term stability of each sample, the surface resistance was measured before and after each sample was exposed to an environment of 65 °C and 90 RH% relative humidity for 240 hours, i.e., the initial resistance and the resistance after 240 hours of exposure to an environment of 65 °C and 90 RH% relative humidity were measured. In this evaluation, a sample having a surface resistance exceeding the critical value of 20 Ω/square was judged to be impractical. The results are shown in Table 1.

TOTAL LIGHT TRANSMITTANCE

The total light transmittance was measured in accordance with "JIS K-7105" by using "NDH 5000 (available from Nippon Denshoku Industries)" . The results are shown in Table 1.

LIGHT ABSORPTION

The transmittance and reflectance at an incidence angle of 5 ° were measured by using a spectroscope "U-4100 (available from Hitachi High Technologies)", and the light absorption amount for each value at a wavelength of 550 nm was defined by the following equation (1).

$$\text{Light Absorption } (\%) = 100 \ (\%) - (\text{Transmittance } (\%) + \text{Reflectance } (\%)) \ ...(1)$$

In other words, the light which are neither reflected nor transmitted was regarded as being converted into (absorbed as) heat in the thin film and the substrate. In practice, although light absorption may appear to increase because of the substantial reduction in transmittance and reflectance due to scattering or the like, since the substrate used in the present disclosure is extremely small in absorption and has a smooth surface, the light absorption obtained by the above formula (1) can be substantially regarded as the absorption by the laminated films. The results are shown in Table 1.

[Table 1]

| | first transparent material layer | | melat layer | | second transparent material layer | | surface resistance (Ω/square) | | total light transmittance (%) | light absorption at 550 nm wavelength (%) |
| | material | thickness (nm) | material | thickness (nm) | material | thickness (nm) | initial | 65°C, 90RH% after 240h | | |
|---|---|---|---|---|---|---|---|---|---|---|
| Ex. 1 | 50%Sn-Zn-0 | 64 | Ag | 7 | ZnO | 46 | 15 | 16 | 91.8 | 4.0 |
| Ex. 2 | 50%Sn-Zn-0 | 64 | Ag | 7 | 10%Sn-Zn-0 | 46 | 15 | 20 | 91.4 | 4.5 |
| Ex. 3 | 10%Sn-Zn-0 | 64 | Ag | 7 | ZnO | 46 | 15 | 18 | 90.2 | 8.0 |
| Ex. 4 | 90%Sn-Zn-0 | 55 | Ag | 7 | ZnO | 51 | 15 | 20 | 90.8 | 7.6 |
| Ex. 5 | 50%Sn-Zn-0 | 63 | Ag | 7 | 5%Al-Zn-O | 46 | 12 | 13 | 92.0 | 3.8 |
| Ex. 6 | 50%Sn-Zn-0 | 63 | Ag | 7 | 10%Ga-Zn-0 | 43 | 13 | 14 | 91.2 | 4.5 |
| Comp. 1 | 50%Sn-Zn-0 | 64 | Ag | 7 | 15%Sn-Zn-0 | 46 | 15 | 155 | 90.7 | 4.6 |
| Comp. 2 | 50%Sn-Zn-0 | 65 | Ag | 7 | 50%Sn-Zn-0 | 47 | 15 | unmeasurable | 92.2 | 3.5 |
| Comp. 3 | ZnO | 64 | Ag | 7 | ZnO | 46 | 15 | 18 | 80.5 | 14.0 |
| Comp. 4 | SnO$_2$ | 47 | Ag | 7 | ZnO | 56 | 15 | 20 | 83.4 | 12.5 |
| Comp. 5 | 5%Sn-Zn-0 | 64 | Ag | 7 | ZnO | 46 | 15 | 18 | 85.0 | 12.2 |
| Comp. 6 | 95%Sn-Zn-0 | 52 | Ag | 7 | ZnO | 51 | 15 | 20 | 88.1 | 11.5 |

Example 1

The sample of Example 1 has a surface resistance of 20 Ω/square or less and a total light transmittance of 90% or more, and a large change in the resistance value is not observed even in a high-temperature, high-humidity environment, indicating that the sample can be used for a long period of time.

Example 2

The sample of Example 2, in which 10 atomic% of tin is added to the second transparent material of Example 1, has a surface resistance of 20 Ω/square or less and a total light transmittance of 90% or more, indicating that the sample can be used for a long period of time, although the resistance value increases as compared with the sample of Example 1 under a high-temperature, high-humidity environment.

Examples 3 and 4

The samples of Examples 3 and 4, in which the concentration of tin in the first transparent material in Example 1 was changed to 10 atom% or 90 atom%, have the surface resistance of 20 Ω/square or less and the total light transmittance of 90% or more, indicating that the samples can be used for a long period of time, although light absorption at a wavelength of 550 nm increases as compared with the sample of Example 1, and the resistance value increases under a high-temperature, high-humidity environment increases.

Examples 5 and 6

The samples of Examples 5 and 6, in which aluminum or gallium is added to the second transparent material of Example 1, have a surface resistance of 20 Ω/square or less and a total light transmittance of 90% or more, and a large change in the resistance value is not observed even in a high-temperature, high-humidity environment, indicating that the sample can be used for a long period of time. The resistance values of the samples of Examples 5 and 6 were slightly reduced as compared with those of Example 1. It is considered that this is because the conductivity of the second transparent material is increased by adding aluminum or gallium to the second transparent material.

Comparative Examples 1 and 2

The samples of Comparative Examples 1 and 2, in which 15 atomic% or 50 atomic% of tin was added to the second transparent material in Example 1, both had initial resistance values satisfied the criteria, but the resistance value was greatly increased in a high-temperature, high-humidity environment. When the surface resistance of the samples of Comparative Examples 1 and 2 was measured by another non-contact resistivity meter instead of the above-described contact resistivity measuring instrument, it was found that the resistance value was almost the same as the initial value even under a high-temperature, high-humidity environment. The reason for this is considered as follows. In the construction of the present technology, the current to be measured flows through the second transparent material layer disposed on the contacting surface to be contact with the measurement terminal, then flows through the metal layer, and back to the measurement terminal through the second transparent material layer. It is considered that the resistance value is determined mostly by the value in the metal layer, and it is presumed that the second transparent material layer, which is only 100 nm or less, was oxidized under a high temperature and high humidity environment and became extremely insulating, so that the current could not be measured by a contact type resistivity meter.

Comparative Example 3 to 6

In the samples of Comparative Examples 3 to 6, in which the content ratio of tin in the first transparent material in Example 1 was changed, the resistance value was stable even in a high-temperature, high-humidity environment, but the total light transmittance was greatly reduced. It is considered that the reason for this is that the light absorption increased because the content of tin in the first transparent material layer was not 10 atomic% or more and 90 atomic% or less, and the transmittance decreased as the light absorption increased. It is presumed that the light absorption is caused by the formation of an absorption layer between the first transparent material layer and the metal (silver) layer as described above.

As described above, the effect of the present technology could be verified from the results of the examples and the comparative examples. The present invention is not limited to the examples described above, and it is obvious that those who skilled in the art can conceive of various alterations or modifications within the scope of the technical idea described in the claims, and it is understood that these also fall naturally within the technical scope of the present invention.

REFERENCE SIGNS LIST

1 conductive laminate, 2 transparent substrate, 3 first transparent material layer, 4 metal layer, 5 second transparent material layer, 10 base film, 11 unwinding roll, 12 winding roll, 21 first can roll, 22 second can roll, 31 optical monitor, 32 optical monitor, SP sputtering chamber

**Claims**

1.  A conductive laminate comprising a first transparent material layer, a metal layer mainly composed of silver, and a second transparent material layer which are laminated on at least one surface of a transparent substrate in this order from the transparent substrate side,

    wherein the first transparent material layer is composed of a composite metal oxide containing at least zinc and tin and containing 10 atomic% or more and 90 atomic% or less of tin, and
    wherein the second transparent material layer is composed of a metal oxide containing zinc and having a tin content of 10 atomic% or less.

2.  The conductive laminate according to claim 1, wherein the second transparent material layer contains 2 atomic% or more of at least one of aluminum and gallium.

3.  The conductive laminate according to claim 1 or 2, wherein the metal layer contains 90 atomic% or more of silver.

4.  The conductive laminate according to any one of claims 1 to 3, wherein the metal layer has a thickness of 5 nm or more.

5.  The conductive laminate according to any one of claims 1 to 4, wherein the transparent substrate comprises one of glass, polyethylene terephthalate (PET), polyethylene naphthalate (PEN), polyaramide, polyimide, polycarbonate, polyethylene, polypropylene, triacetylcellulose (TAC), and polycycloolefin (COC, COP), and a laminate of any of these.

6.  The conductive laminate according to any one of claims 1 to 5, wherein the content of tin in the second transparent material layer is less than the content of tin in the first transparent material layer.

7.  A touch panel comprising the conductive laminate according to any one of claims 1 to 6 used as at least one pole of an electrode.

8.  A light control element comprising the conductive laminate according to any one of claims 1 to 6 used as at least one pole of an electrode.

9.  An electrophoretic optical element comprising the conductive laminate according to any one of claims 1 to 6 used as at least one pole of an electrode.

10. A light emitting element comprising the conductive laminate according to any one of claims 1 to 6 used as at least one pole of an electrode.

11. An antenna configured by using at least one conductive laminate according to any one of claims 1 to 6.

12. A method for manufacturing a conductive laminate; comprising:

    a step of laminating, on at least one surface of a transparent substrate, a first transparent material layer, a metal layer mainly composed of silver, and a second transparent material layer in this order from the transparent substrate side,
    wherein the first transparent material layer is composed of a composite metal oxide containing at least zinc and tin and containing 10 atomic% or more and 90 atomic% or less of tin, and
    wherein the second transparent material layer is composed of a metal oxide containing zinc and having a tin content of 10 atomic% or less.

**FIG.1**

FIG.2

## INTERNATIONAL SEARCH REPORT

| International application No. |
|---|
| PCT/JP2021/007001 |

### A. CLASSIFICATION OF SUBJECT MATTER
B32B 9/00(2006.01)i; C23C 14/06(2006.01)i; B32B 7/025(2019.01)i; G06F 3/041(2006.01)i
FI: B32B9/00 A; B32B7/025; C23C14/06 N; G06F3/041 495

According to International Patent Classification (IPC) or to both national classification and IPC

### B. FIELDS SEARCHED

Minimum documentation searched (classification system followed by classification symbols)
B32B9/00; C23C14/06; B32B7/025; G06F3/041

Documentation searched other than minimum documentation to the extent that such documents are included in the fields searched
| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2007-250430 A (SUMITOMO METAL MINING CO., LTD.) 27 September 2007 (2007-09-27) claims 1, 5, 6, paragraphs [0002], [0006]-[0044], tables 1, 2, fig. 1-5 | 1-5, 7-12 |
| A | entire text, all drawings | 6 |
| X | JP 2016-506037 A (SAINT-GOBAIN GLASS FRANCE) 25 February 2016 (2016-02-25) paragraphs [0002], [0003], examples, tables 1, 2, fig. 1 | 1-12 |

☐ Further documents are listed in the continuation of Box C.  ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 May 2021 (14.05.2021) | 25 May 2021 (25.05.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**
Information on patent family members

International application No.

PCT/JP2021/007001

| Patent Documents referred in the Report | Publication Date | Patent Family | Publication Date |
|---|---|---|---|
| JP 2007-250430 A | 27 Sep. 2007 | (Family: none) | |
| JP 2016-506037 A | 25 Feb. 2016 | US 2015/0311470 A1 paragraphs [0002], [0003], examples, tables 1, 2, fig. 1 WO 2014/091136 A1 EP 2932539 A1 FR 2999807 A KR 10-2015-0097587 A CN 104969376 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020035784 A
- JP 4820738 B
- JP 4961786 B
- JP 2014034701 A

**Non-patent literature cited in the description**

- *Appl. Phys. A,* 2014, vol. 116, 1287-1291